# FASCICULE DE BREVET EUROPEEN

(11) **EP 1 206 856 B1**
(45) Date de publication et mention de la délivrance du brevet: **13.04.2011**
(21) Numéro de dépôt: 99957325.6
(22) Date de dépôt: 26.11.1999
(51) Int. Cl.: H04B 11/00, G04G 99/00

(54) **SYSTEME DE COMMUNICATION ACOUSTIQUE ENTRE UNE UNITE PORTATIVE ET UN TERMINAL DE COMMUNICATION**
AKUSTISCHES KOMMUNIKATIONSSYSTEM ZWISCHEN EINER TRAGBAREN EINHEIT UND EINER KOMMUNIKATIONSSTATION
SOUND COMMUNICATION SYSTEM BETWEEN A PORTABLE UNIT AND A COMMUNICATION TERMINAL

(30) Priorité: 03.08.1999 EP 99115319
(43) Date de publication de la demande: 22.05.2002
(73) Titulaire: ETA SA Manufacture Horlogère Suisse, 2540 Grenchen (CH)
(72) Inventeur: FLEURY, Emmanuel, CH-2740 Moutier (CH); BLONDEAU, Fabien, CH-2525 Le Landeron (CH); BARRAS, David, CH-2540 Grenchen (CH); MEISTER, Pierre-André, CH-2502 Biel (CH)
(74) Mandataire: Ravenel, Thierry Gérard Louis
(86) Numéro de dépôt international: PCT/EP1999/009201
(87) Numéro de publication internationale: WO 2001/010064

(56) Documents cités:
- DE-A- 2 829 651
- US-A- 4 242 745
- US-A- 4 800 543

## Description

La présente invention concerne un système de communication entre une unité portative telle qu'une montre et un terminal de communication tel qu'un ordinateur personnel ou PC.

On connaît par le brevet US 5,848,027 au nom de Biometrics, Inc., un système pour le traitement de données personnelles. Ce système permet, par exemple, de contrôler les performances d'un athlète tel qu'un coureur à pieds. II permet d'enregistrer la date et l'heure de la course, le temps réalisé à chaque tour de piste, ou encore le temps final cumulé accompli par le sportif. Le système permet également d'enregistrer les valeurs de certains paramètres physiologiques tels que le rythme cardiaque ou un électrocardiogramme (ECG) qui reflètent l'effort fourni par l'athlète au cours de son activité sportive. Toutes ces informations vont ensuite être transmises, via une liaison acoustique, à un ordinateur personnel dans lequel ces données vont être traitées, analysées, puis finalement affichées à l'écran dudit ordinateur.

Le système Biometrics susdécrit permet avantageusement d'enregistrer des données personnelles dans une montre, puis de transférer ces données par ondes acoustiques vers un ordinateur où elles vont être traitées et analysées. Ce système n'est malheureusement pas bidirectionnel. Il n'est donc pas possible de transférer des informations depuis l'ordinateur vers la montre, ce qui limite considérablement les applications possibles du système Biometrics.

On connaît par ailleurs des systèmes de communication dans lesquels des données sont échangées de manière bidirectionnelle via une liaison sans fil entre un objet portatif et un terminal de communication. A titre d'exemple, on peut citer le cas des agendas électroniques aptes à communiquer par ondes radiofréquence avec un ordinateur personnel.

Lorsqu'il est à son bureau, l'utilisateur d'un tel système peut introduire dans son ordinateur l'emploi du temps de sa semaine de travail, puis transférer ces données vers son agenda de poche. Pendant ses déplacements, l'utilisateur peut ainsi, à tout moment, consulter son agenda et voir quelles sont ses obligations et disponibilités. Au cours d'une réunion, rendez-vous peut alors être pris pour une nouvelle séance de travail programmée à une date ultérieure. L'utilisateur peut ensuite introduire ce nouveau rendez-vous dans son agenda électronique ainsi que, par exemple, l'identité et les coordonnées téléphoniques de son interlocuteur. De retour à son bureau, l'utilisateur pourra transférer les nouvelles données introduites dans son agenda vers l'ordinateur et mettre son emploi du temps à jour.

On a décrit un système de communication sans fil par ondes radiofréquence. Il va de soi que d'autres systèmes de communication sans fil, par exemple par liaison infrarouge ou par liaison inductive, peuvent également être employés. Tous ces systèmes permettent avantageusement d'établir une communication bidirectionnelle pour l'échange d'informations entre une unité portative et un terminal de communication. Ces systèmes ont cependant l'inconvénient de nécessiter des moyens d'émission et/ou de réception propres au type de liaison sans fil utilisée, moyens dont les prix de revient et d'installation sont souvent très élevés.

Le document US 4,800,543 concerne une montre-bracelet comprenant un circuit de communication, une mémoire et un émetteur. Un code d'identification personnel propre à l'utilisateur de la montre est stocké en mémoire. Une communication sans fil est établie entre un dispositif de lecture et la montre. Le dispositif de lecture est muni d'un clavier à touches au moyen duquel l'utilisateur peut introduire un code d'identification. Le dispositif de lecture envoie le code à la montre qui compare ce code au code enregistré dans sa mémoire. Si les deux codes d'identification coïncident, la montre autorise la transaction. La montre contient un dispositif émetteur/récepteur qui peut être un transducteur piézoélectrique.

Le document DE 28 29 651 se rapporte à un dispositif de synchronisation de montres électroniques dans lequel la communication codée entre l'appareil de programmation et les montres à programmer et inversement peut s'effectuer au moyen d'ondes acoustiques.

Le document US 4,242,745 décrit une pièce d'horlogerie électronique comprenant un transducteur électroacoustique pour émettre des signaux acoustiques indiquant une heure d'alarme, et également pour recevoir des informations sous la forme de signaux acoustiques permettant de commander différentes fonction de la pièce d'horlogerie. Des informations acoustiques codées sont fournies au transducteur par un dispositif spécial prévu à cet effet, et servent à commander différentes fonctions de la pièce d'horlogerie au moyen d'un circuit logique de commande de la montre et du transducteur. Le transducteur comprend un élément piézoélectrique qui est utilisé à la fois pour indiquer une heure d'alarme et pour capter des signaux acoustiques. Un amplificateur opérationnel fonctionne comme détecteur de niveau et produit un signal de sortie seulement si le niveau du signal d'entrée fourni par le transducteur est suffisant pour atteindre un seuil. Le transducteur agit à la façon d'un microphone vis-à-vis des signaux acoustiques provenant de l'extérieur de la pièce d'horlogerie, et produit des signaux à l'entrée du détecteur. La pièce d'horlogerie peut être placée, par exemple, sur un dispositif spécial qui fournit au transducteur des signaux acoustiques codés qui peuvent remplacer les informations qui sont habituellement introduites dans la montre au moyen de boutons-poussoirs.

Aucun des trois documents analysés ci-dessus ne décrit, ni même ne suggère des moyens de réception et de traitement d'un signal acoustique comprenant un amplificateur du signal électrique produit par un transducteur électroacoustique qui capte les signaux acoustiques et un démodulateur qui démodule le signal produit par le transducteur électroacoustique et amplifié par l'amplificateur avant de le transmettre à un microprocesseur.

La présente invention a pour but de remédier aux problèmes et inconvénients ci-dessus ainsi qu'à d'autres encore en proposant un système de communication sans fil fiable et peu coûteux entre une unité portative et un terminal de communication.

A cet effet, la présente invention concerne un système de communication entre une unité portative, telle qu'une montre, et un terminal de communication tel qu'un ordinateur personnel ou PC, caractérisé en ce que le terminal de communication comprend au moins des moyens d'émission d'un signal acoustique portant une information, et en ce que l'unité portative comprend au moins des moyens de traitement pour traiter des données, et des moyens de réception et de conversion pour capter ledit signal acoustique et pour convertir ce signal acoustique en données destinées à être traitées par lesdits moyens de traitement.

Grâce à ces caractéristiques, il est possible d'introduire des données, par exemple dans un ordinateur personnel, puis de transférer ces données via une liaison acoustique vers l'unité portative telle qu'une montre-bracelet. On obtient ainsi un système de communication par ondes acoustiques beaucoup plus simple et, par conséquent, moins coûteux que les autres systèmes de communication, par exemple par infrarouge ou par radiofréquence, connus actuellement. La plupart des terminaux de communication peuvent, en effet, être utilisés dans le cadre de la présente invention sans qu'il soit nécessaire de les modifier ou de leur adjoindre des éléments d'émission et/ou de réception propres au type de liaison sans fil utilisée. Ainsi, lorsque le terminal de communication est un ordinateur personnel, on peut utiliser les haut-parleurs dont ces ordinateurs sont maintenant couramment équipés pour envoyer un signal acoustique vers l'unité portative. Il suffit, à cet effet, d'introduire dans l'ordinateur un programme permettant de moduler le signal acoustique pour que celui-ci puisse ensuite être décodé par l'unité portative. De même, lorsque le signal acoustique est émis par un poste de radio ou par un téléviseur, il suffit de s'assurer qu'avant sa diffusion, ce signal ait été convenablement modulé, afin qu'il puisse ensuite être reçu et converti en données propres à être traitées par les moyens de traitement de l'unité portative.

Selon un autre de ses aspects, la présente invention concerne un système de communication du genre susmentionné, caractérisé en ce que l'unité portative comprend en outre des moyens de conversion et d'émission pour convertir des données fournies par lesdits moyens de traitement de ladite unité portative en un signal acoustique portant une information et pour émettre un signal acoustique, et en ce que le terminal de communication comprend en outre des moyens de traitement pour traiter des données et des moyens de réception et de conversion pour recevoir ledit signal acoustique émis par l'unité portative et pour convertir ce signal acoustique en données destinées à être traitées par lesdits moyens de traitement dudit terminal de communication.

Grâce à ces autres caractéristiques, on peut non seulement transmettre des données depuis le terminal de communication vers l'unité portative, mais également émettre des données depuis l'unité portative en direction du terminal d'information, ce qui permet d'accroître considérablement le nombre d'applications possibles du système de communication selon l'invention.

D'autres caractéristiques et avantages de la présente invention apparaîtront plus clairement à la lecture de la description détaillée qui suit d'un exemple de réalisation du système de communication selon l'invention, cet exemple étant donné à titre purement illustratif et non limitatif, en liaison avec les dessins annexés dans lesquels :
- la figure 1 est une représentation schématique d'une première variante de réalisation du système de communication entre une unité portative et un terminal de communication selon l'invention;
- la figure 2 est une représentation schématique d'une seconde variante de réalisation du système de communication selon l'invention;
- la figure 3 est une représentation schématique d'une troisième variante de réalisation du système de communication selon l'invention;
- la figure 4 représente un schéma électrique d'un circuit convertisseur d'un signal acoustique en données destinées à être traitées par les moyens de traitement de l'unité portative;
- la figure 5 représente les niveaux de tension en fonction du temps en deux endroits du circuit de la figure 4, et
- la figure 6 représente les niveaux de tension en fonction du temps en deux endroits du circuit de la figure 4 lorsque ce circuit est utilisé comme récepteur d'ondes sonores.

Au sens de l'invention, on entendra par unité portative tout objet de petites dimensions tel que, de manière préférée mais non limitative, une montre-bracelet, susceptible de capter un signal acoustique portant de l'information et à transformer ce signal acoustique en données aptes à être traitées par des moyens de traitement pour extraire l'information portée par le signal acoustique. Selon une caractéristique complémentaire de l'invention, l'objet portatif est également capable d'émettre des signaux acoustiques codés avec de l'information.

Au sens de l'invention, on entendra également par terminal de communication tout dispositif tel que, par exemple, un ordinateur personnel, un poste de radio, un téléviseur ou encore un serveur vocal accessible par téléphone, susceptible d'émettre des signaux acoustiques portant de l'information. Selon une caractéristique complémentaire de l'invention, le terminal de communication est également capable de capter des signaux acoustiques codés avec de l'information et de transformer ces signaux acoustiques en données aptes à être traitées par des moyens de traitement pour extraire l'information portée par les signaux acoustiques.

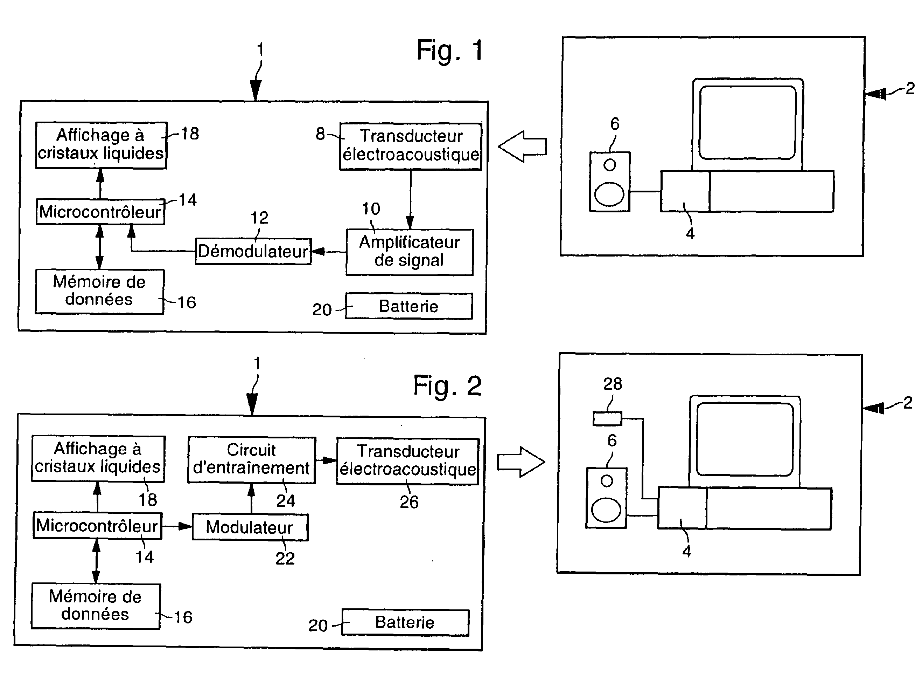

La figure 1 montre schématiquement un objet portatif tel que, par exemple, une pièce d'horlogerie, désigné dans son ensemble par la référence numérique générale 1, et un terminal de communication tel que, par exemple, un ordinateur personnel ou PC, désigné dans son ensemble par la référence numérique générale 2.

Conformément à l'invention, le terminal de communication 2 comprend des moyens d'émission de signaux acoustiques portant de l'information. Dans l'exemple représenté à la figure 1, ces moyens se présentent sous la forme d'une carte son 4 disposée à l'intérieur de l'ordinateur personnel, et de un ou plusieurs haut-parleurs 6.

L'un des avantages de la présente invention réside ainsi dans le fait qu'il n'est pas nécessaire de modifier la structure de l'ordinateur ou de lui adjoindre des éléments d'émission propres au type de liaison sans fil utilisée. Il suffit, pour pouvoir mettre l'invention en oeuvre, d'introduire dans l'ordinateur un programme lui permettant de moduler le signal acoustique de façon à ce que ce signal puisse ensuite être convenablement décodé par l'unité portative 1.

Lorsque le terminal de communication 2 émet un signal acoustique portant une information, ce signal est aussitôt capté par les moyens de réception de l'unité portative 1. Ces moyens de réception sont formés par un transducteur électroacoustique 8 qui joue le rôle d'un microphone et qui transforme classiquement le signal acoustique incident en une succession de signaux électriques qui vont ensuit être convertis par des moyens de conversion de l'unité portative 1 en données destinées à être traitées par des moyens de traitement afin d'extraire l'information utile portée par le signal acoustique. Dans l'exemple représenté à la figure 1, les moyens de conversion de l'unité portative 1 comprennent un amplificateur 10 du signal électrique produit par le transducteur électroacoustique 8 et un démodulateur 12 relié à l'amplificateur de signal 10 et destiné à démoduler le signal acoustique reçu par le transducteur 8 et à transmettre le signal démodulé sur une entrée d'un microcontrôleur 14. Le microcontrôleur 14 constitue les moyens de traitement de l'objet portatif 1. L'information portée par le signal acoustique émis par le terminal de communication 2, démodulée par le démodulateur 12 et traitée par le microcontrôleur 14, peut être stockée dans une mémoire 16 de l'objet portatif 1 et/ou affichée sur un dispositif d'affichage 18 par exemple à cristaux liquides. Une batterie 20, éventuellement rechargeable, alimente l'unité portative 1 en courant électrique.

Dans tout ce qui suit, les éléments identiques à ceux décrits précédemment seront désignés par les mêmes références numériques.

Selon un autre aspect de l'invention, on examine maintenant en liaison avec la figure 2 le cas où l'unité portative 1 émet un signal acoustique en direction du terminal de communication 2. Dans ce cas, l'unité portative 1 comprendra, outre les moyens décrits ci-dessus, des moyens de conversion et d'émission pour convertir des données fournies par les moyens de traitement de l'unité portative 1 en un signal acoustique modulé contenant des informations et émettre ce signal. Comme représenté à la figure 2, les moyens de conversion de l'unité portative 1 comprennent un circuit de modulation 22 qui attaque, via un circuit d'entraînement 24, les moyens d'émission, à savoir un transducteur électroacoustique 26 jouant le rôle de haut-parleur. Les moyens de traitement de l'unité portative 1, c'est-à-dire le microcontrôleur 14, effectuent la commande du circuit de modulation 22 à l'aide de données en provenance de la mémoire 16 associée audit microcontrôleur 14.

Lorsque l'unité portative 1 émet un signal acoustique contenant des informations, ce signal est aussitôt capté par les moyens de réception, en l'occurrence un microphone 28, du terminal de communication 2. Ce signal acoustique est ensuite converti par des moyens de conversion du terminal de communication 2 en données aptes à être traitées par des moyens de traitement dudit terminal de communication 2. Dans le cas où le terminal de communication 2 est un ordinateur personnel ou PC, les moyens de conversion du signal acoustique portant une information sont classiquement constitués par la carte son 4 décrite précédemment qui est capable de convertir le signal acoustique reçu par le microphone 28 en données binaires qui vont être transmises sur une entrée du microcontrôleur (non représenté) de l'ordinateur personnel pour y être démodulées et transformées en informations qui pourront être stockées dans une mémoire dudit microcontrôleur.

Dans le cas où l'unité portative 1 émet un signal acoustique contenant des informations vers l'ordinateur personnel, un avantage de la présente invention réside, ici aussi, dans le fait qu'il n'est pas nécessaire de modifier l'ordinateur personnel ou de lui ajouter des composants qui seraient propres au type de liaison sans fil utilisée.

Selon un autre de ses avantages, la présente invention procure un système de communication bidirectionnelle par ondes acoustiques entre une unité portative 1 et un terminal de communication 2. Un tel système est beaucoup plus simple à mettre en oeuvre et moins coûteux que d'autres systèmes de communication bidirectionnelle utilisant, par exemple, une liaison infrarouge ou une liaison radiofréquence. D'autre part, par rapport aux systèmes de l'art antérieur utilisant la communication par ondes acoustiques mais seulement de manière unidirectionnelle d'une montre vers un PC, le système selon l'invention permet un nombre d'applications beaucoup plus vaste.

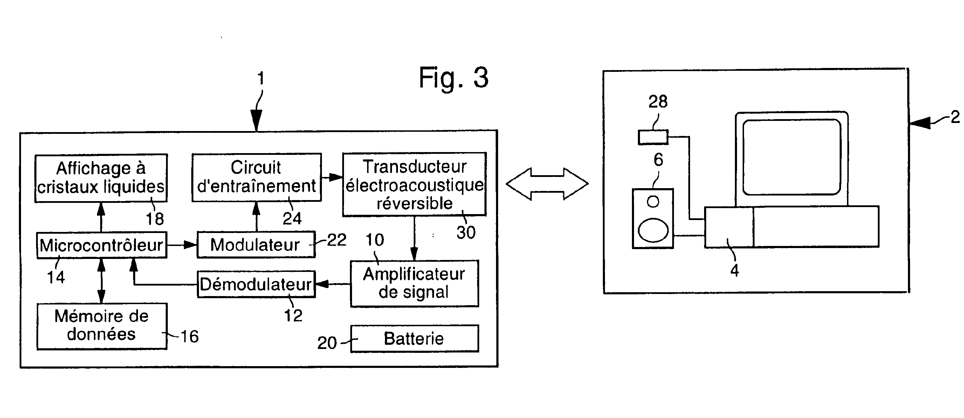

Selon une caractéristique complémentaire de l'invention, les moyens de conversion et d'émission et les moyens de réception et de conversion de l'unité portative 1 utilisent un seul et même transducteur électroacoustique 30 qui fonctionne de manière réversible, c'est-à-dire à la fois comme microphone et comme haut-parleur (voir figure 3). Lorsque le transducteur électroacoustique 30 fonctionne en mode récepteur, le signal électrique qu'il produit sous l'effet d'un signal acoustique incident est amplifié par l'amplificateur 10 puis démodulé par le démodulateur 12. Le signal démodulé par le démodulateur 12 est ensuite transmis à l'entrée du microcontrôleur 14. Inversement, lorsque le transducteur électroacoustique 30 sert de haut-parleur, il est attaqué par le circuit de modulation 22 via le circuit d'entraînement 24. Le microcontrôleur 14 effectue la commande du circuit de modulation 22 à l'aide des données en provenance de la mémoire 16 associée audit microcontrôleur 14.

On examine maintenant un mode de réalisation particulier du transducteur électroacoustique 30 qui consiste à utiliser comme récepteur et/ou émetteur d'ondes acoustiques un vibreur piézo-électrique habituellement employé comme générateur de son dans les montres comportant un dispositif d'alarme. On examine également un circuit électronique comparateur qui est branché aux bornes du vibreur piézo-électrique et qui produit à sa sortie un signal pseudo-numérique représentatif du signal sonore incident capté par le vibreur et permettant de commander les fonctions d'un microcontrôleur.

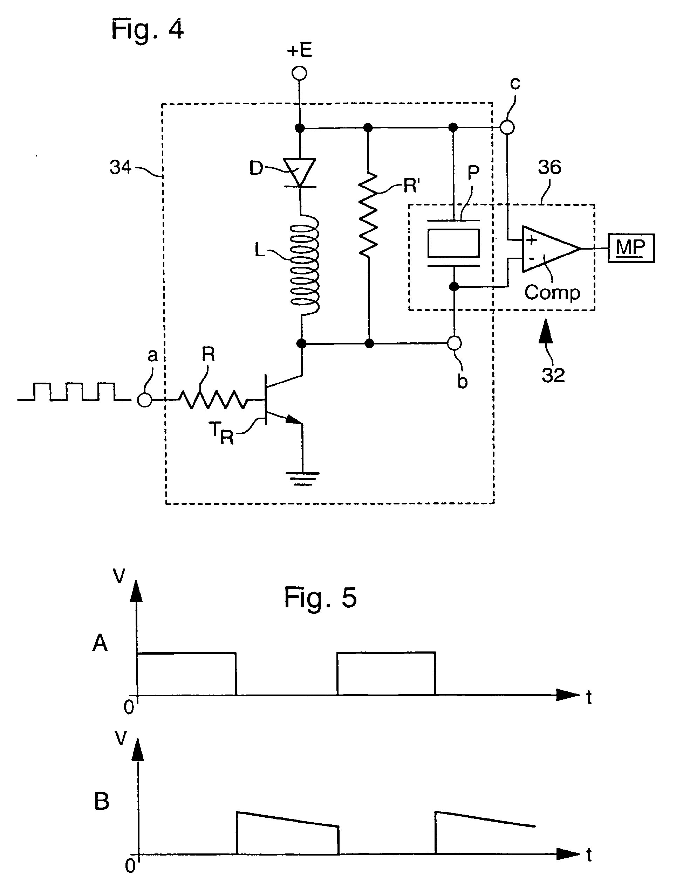

La figure 4 représente un convertisseur électronique désigné dans son ensemble par la référence numérique générale 32. Comme il ressort de la figure 4, le convertisseur électronique 32 susmentionné est constitué par l'association d'un circuit d'entraînement 34 d'un vibreur piézo-électrique P et d'un circuit de comparaison 36 dont les principes de fonctionnement respectifs vont être décrits ci-dessous.

Le circuit d'entraînement 34 du vibreur piézo-électrique P comprend une branche de circuit dans laquelle une bobine L et une diode D sont montées en série, une résistance R' et le vibreur piézo-électrique P étant branchés en parallèle sur cette branche de circuit.

Le circuit d'entraînement 34 reçoit sur une borne d'entrée "a" un signal impulsionnel de commande à créneaux "v" (courbe A, figure 5). Ce signal de commande est appliqué à travers une résistance R à la base d'un transistor T_{R.} Lorsque le transistor T_{R} est rendu passant par une impulsion de commande, la bobine L est parcourue par un courant fourni par une source de tension +E, tandis que le point de connexion "b" du vibreur piézo-électrique P est relié à la masse du circuit d'entraînement 34. Lorsque le transistor T_{R} passe à l'état bloqué lors du front descendant de chaque impulsion de commande, toute l'énergie accumulée dans la bobine L est transmise aux bornes du vibreur P, chargeant celui-ci à une tension "v" (courbe B, figure 5) supérieure à la tension d'alimentation +E. Lorsqu'à son tour le vibreur P commence à se décharger, la diode D bloque le retour du courant. On notera qu'entre deux signaux impulsionnels de commande successifs, le vibreur piézo-électrique P peut tout de même se décharger partiellement à travers la résistance R'. Ainsi, lorsque plus aucun signal de commande n'est appliqué au transistor T_{R} et que celui-ci se trouve donc à l'état bloqué, la tension aux bornes du vibreur P retrouve progressivement sa valeur de repos +E.

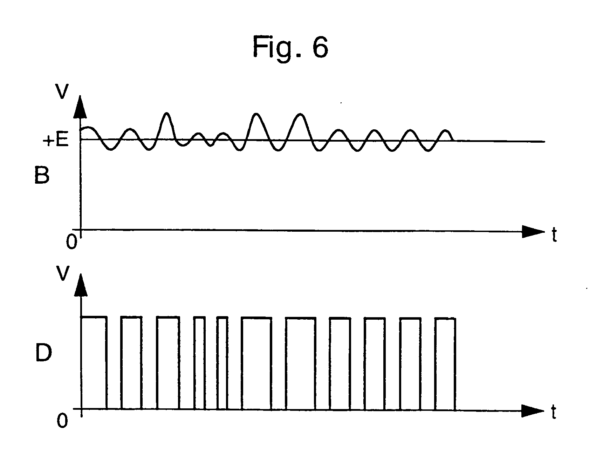

On examine maintenant le fonctionnement du circuit de comparaison 36. Celui-ci comprend des moyens de comparaison constitués par un comparateur analogique-digital COMP. L'une des entrées du comparateur COMP est reliée à un point de connexion "c" de la source d'alimentation continue +E, tandis que l'autre entrée dudit comparateur COMP est reliée au point de sortie "b" du circuit d'entraînement 34, autrement dit au point de connexion entre le vibreur piézo-électrique P et le transistor T_{R}. Comme déjà précisé ci-dessus, en l'absence de signal de commande appliqué sur la base du transistor T_{R}, le vibreur P est au repos et la tension à ses bornes est égale à la tension d'alimentation +E (courbe B, figure 6). Dans ces conditions, le vibreur piézo-électrique P n'est plus utilisé comme générateur de son mais peut, au contraire, être employé comme récepteur d'ondes acoustiques. Ainsi, sous l'effet d'un signal sonore incident, la tension aux bornes du vibreur P va se mettre à osciller de part et d'autre de sa tension de repos +E comme le montre la courbe B de la figure 6. Le comparateur COMP compare ensuite la tension produite par le vibreur P avec sa tension de référence qui est la tension d'alimentation +E du circuit d'entraînement 34. A chaque fois que la tension produite par le vibreur piézo-électrique P excède la tension de référence +E, le comparateur COMP va produire un signal impulsionnel à sa sortie "d" (courbe D, figure 6). Il est ainsi possible de transformer un signal acoustique en un signal électrique pseudo-numérique. Le signal pseudo-numérique va ensuite être utilisé pour commander un microprocesseur MP comme cela est décrit en détail dans la demande de brevet européen enregistrée sous le numéro 99115319.8 au nom de la Demanderesse.

## Revendications

1. Système de communication entre une unité portative, telle qu'une montre, et un terminal de communication tel qu'un ordinateur personnel ou PC, le terminal de communication (2) comprenant au moins des moyens d'émission d'un signal acoustique portant une information, et l'unité portative (1) comprenant au moins des moyens de traitement pour traiter des données, et des moyens de réception et de conversion comportant un transducteur électroacoustique (8) pour capter ledit signal acoustique et pour convertir ce signal acoustique en données destinées à être traitées par lesdits moyens de traitement, ce système de communication étant **caractérisé en ce que** les moyens de réception de l'unité portative (1) comprennent un amplificateur (10) du signal électrique produit par le transducteur électroacoustique (8) et un démodulateur (12) relié à l'amplificateur de signal (10) et destiné à démoduler le signal acoustique reçu par le transducteur (8) et à transmettre le signal démodulé sur une entrée d'un microcontrôleur (14) qui constitue les moyens de traitement de ladite unité portative (1), l'information portée par le signal acoustique émis par le terminal de communication (2), démodulée par le démodulateur (12) et traitée par le microcontrôleur (14) étant stockée dans une mémoire (16) associée audit microcontrôleur (14).

2. Système de communication selon la revendication 1, **caractérisé en ce que** l'unité portative (1) comprend en outre des moyens de conversion et d'émission pour convertir des données fournies par lesdits moyens de traitement de ladite unité portative (1) en un signal acoustique portant une information et pour émettre un signal acoustique, et **en ce que** le terminal de communication (2) comprend en outre des moyens de traitement pour traiter des données et des moyens de réception et de conversion pour recevoir ledit signal acoustique émis par l'unité portative (1) et pour convertir ce signal acoustique en données destinées à être traitées par lesdits moyens de traitement dudit terminal de communication (2).

3. Système de communication selon la revendication 2, **caractérisé en ce que** les moyens de conversion et d'émission de l'unité portative (1) comprennent un transducteur électroacoustique (26).

4. Système de communication selon la revendication 3, **caractérisé en ce que** les moyens de conversion et d'émission de l'unité portative (1), et les moyens de réception et de conversion de l'unité portative (1) mettent en oeuvre un même transducteur électroacoustique (30).

5. Système de communication selon l'une quelconque des revendications 3 ou 4, **caractérisé en ce que** les moyens de conversion de l'unité portative (1) comprennent un circuit de modulation (22) qui attaque, via un circuit d'entraînement (24), le transducteur électroacoustique (26), les moyens de traitement de l'unité portative (1) qui comprennent un microcontrôleur (14) effectuant la commande du circuit de modulation (22) à l'aide de données en provenance d'une mémoire (16) associée audit microcontrôleur (14).

6. Système de communication selon l'une quelconque des revendications précédentes, **caractérisé en ce que** les moyens de réception et de conversion de l'unité portative (1) comprennent un circuit générateur de son muni d'un vibreur piézo-électrique (P) formant un moyen de réception du signal acoustique.

7. Système de communication selon la revendication 6, **caractérisé en ce que** les moyens de réception et de conversion de l'unité portative (1) comprennent en outre des moyens de comparaison (COMP) pour comparer la tension produite par le vibreur piézo-électrique (P) lors de la réception du signal acoustique avec une tension de référence (+E), ces moyens de comparaison (COMP) produisant un signal électrique représentatif de l'information portée par ledit signal acoustique.

## Claims

1. Communication system between a portable unit, such as a watch, and a communication terminal such as a personal computer or PC, the communication terminal (2) including at least means for transmitting an acoustic signal carrying data, and the portable unit (1) including at least processing means for processing data, and receiving and conversion means including an electro-acoustic transducer (8) for picking up said acoustic signal and converting said acoustic signal into data intended to be processed by said processing means, this communication system being **characterised in that** the receiving means of the portable unit (1) include an amplifier (10) for the electric signal generated by the electro-acoustic transducer (8) and a demodulator (12) connected to the signal amplifier (10) and intended for demodulating the acoustic signal received by the transducer (8) and to transmit the demodulated signal to an input of a microcontroller (14) which constitutes the processing means of said portable unit (1), the data carried by the acoustic signal transmitted by the communication terminal (2) demodulated by the demodulator (12) and processed by the microcontroller (14) being stored in a memory (16) associated with said microcontroller (14).

2. Communication system according to claim 1, **characterised in that** the portable unit (1) further includes conversion and transmission means for converting data supplied by said processing means of said portable unit (1) into an acoustic signal carrying data and for transmitting an acoustic signal, and **in that** the communication terminal (2) further includes processing means for processing data and receiving and conversion means for receiving said acoustic signal transmitted by the portable unit (1) and for converting said acoustic signal into data intended to be processed by said processing means of said communication terminal (2).

3. Communication terminal according to claim 2, **characterised in that** the reception and conversion means of the portable unit (1) include an electro-acoustic transducer (26).

4. Communication system according to any of claims 2 to 4, **characterised in that** the conversion and transmission means of the portable unit (1) and the receiving and conversion means of the portable unit (1) implement the same electro-acoustic transducer (30).

5. Communication system according to claims 3 or 4, **characterised in that** the conversion means of the portable unit (1) include a modulation circuit (22) which, via a drive circuit (24), activates the electro-acoustic transducer (26), the processing means of the portable unit (1) which include a microcontroller (14) controlling the modulation circuit (22) using data originating from a memory (16) associated with said microcontroller (14).

6. Communication system according to any of the preceding claims, **characterised in that** the receiving and conversion means of the portable unit (1) include a sound generator circuit provided with a piezoelectric vibrator (P) forming receiving means for the acoustic signal,

7. Communication system according to claim 6, **characterised in that** the receiving and conversion means of the portable unit (1) further include comparison means (COMP) for comparing the voltage generated by the piezoelectric vibrator (P) when the acoustic signal is received with a reference voltage (+E), these comparison means (COMP) generating an electric signal representative of the data carried by said acoustic signal.

## Patentansprüche

1. System für die Kommunikation zwischen einer tragbaren Einheit wie etwa einer Uhr und einem Kommunikationsendgerät wie etwa einem Personal Computer oder PC, wobei das Kommunikationsendgerät (2) wenigstens Mittel zum Senden eines eine Information transportierenden Schallsignals umfasst und die tragbare Einheit (1) wenigstens Verarbeitungsmittel zum Verarbeiten von Daten und Mittel zum Empfangen und Umsetzen, die einen elektroakustischen Wandler (8) enthalten, um das Schallsignal zu erfassen und um dieses Schallsignal in Daten umzusetzen, die dazu bestimmt sind, durch die Verarbeitungsmittel verarbeitet zu werden, umfasst, wobei dieses Kommunikationssystem **dadurch gekennzeichnet ist, dass** die Empfangsmittel der tragbaren Einheit (1) einen Verstärker (10) für das durch den elektroakustischen Wandler (8) erzeugte elektrische Signal und einen mit dem Signalverstärker (10) verbundenen Demodulator (12), der dazu bestimmt ist, das von dem Wandler (8) empfangene Schallsignal zu demodulieren und das demodulierte Signal zu einem Eingang eines die Verarbeitungsmittel der tragbaren Einheit (1) bildenden Mikrocontrollers (14) zu senden, umfassen, wobei die Information, die von dem Schallsignal transportiert wird, das von dem Kommunikationsendgerät (2) ausgesendet wird, von dem Demodulator (12) demoduliert und von dem Mikrocontroller (14) verarbeitet wird, in einem dem Mikrocontroller (14) zugeordneten Speicher (16) gespeichert ist.

2. Kommunikationssystem nach Anspruch 1, **dadurch gekennzeichnet, dass** die tragbare Einheit (1) außerdem Umsetzungs- und Sendemittel enthält, um von den Verarbeitungsmittein der tragbaren Einheit (1) gelieferte Daten in ein Schallsignal umzusetzen, das eine Information transportiert, und um ein Schallsignal auszusenden, und dass das Kommunikationsendgerät (2) außerdem Verarbeitungsmittel zum Verarbeiten von Daten und Empfangs- und Umsetzungsmittel, um das von der tragbaren Einheit (1) ausgesendete Schallsignal zu empfangen und um dieses Schallsignal in Daten umzusetzen, die dazu bestimmt sind, von den Verarbeitungsmitteln des Kommunikationsendgeräts (2) verarbeitet zu werden, umfasst.

3. Kommunikationssystem nach Anspruch 2, **dadurch gekennzeichnet, dass** die Umsetzungs- und Sendemittel der tragbaren Einheit (1) einen elektroakustischen Wandler (26) umfassen.

4. Kommunikationssystem nach Anspruch 3, **dadurch gekennzeichnet, dass** die Umsetzungs- und Sendemittel der tragbaren Einheit (1) sowie die Empfangs- und Umsetzungsmittel der tragbaren Einheit (1) denselben akustischen Wandler (30) verwenden.

5. Kommunikationssystem nach einem der Ansprüche 3 oder 4, **dadurch gekennzeichnet, dass** die Umsetzungsmittel der tragbaren Einheit (1) eine Modulationsschaltung (22) umfassen, die über eine Treiberschaltung (24) den elektroakustischen Wandler (26) ansteuert, wobei die Verarbeitungsmittel der tragbaren Einheit (1), die einen Mikrocontroller (14) umfassen, die Steuerung der Modulationsschaltung (22) mit Hilfe von Daten von einem dem Mikrocontroller (14) zugeordneten Speicher (16) ausführen.

6. Kommunikationssystem nach einem der vorhergehenden Ansprüche, **dadurch gekennzeichnet, dass** die Empfangs- und Umsetzungsmittel der tragbaren Einheit (1) eine Schallgeneratorschaltung umfassen, die mit einem piezoelektrischen Vibrator (P) versehen ist, der ein Mittel zum Empfangen des Schallsignals bildet.

7. Kommunikationssystem nach Anspruch 6, **dadurch gekennzeichnet, dass** die Empfangs- und Umsetzungsmittel der tragbaren Einheit (1) außerdem Vergleichsmittel (COMP) umfassen, um die von dem piezoelektrischen Vibrator (P) bei Empfang des Schallsignals erzeugte Spannung mit einer Referenzspannung (+E) zu vergleichen, wobei diese Vergleichsmittel (COMP) ein elektrisches Signal erzeugen, das die von dem Schallsignal transportierte Information repräsentiert.
